# EUROPEAN PATENT SPECIFICATION

(11) **EP 4 716 100 B1**
(45) Date of publication and mention of the grant of the patent: **25.11.2026**
(21) Application number: 25196169.4
(22) Date of filing: 15.08.2025
(51) Int. Cl.: H04B 1/00, H04B 1/18

(54) **RADIO-FREQUENCY SWITCHING CIRCUIT AND METHOD FOR OPERATING THE SAME**
HOCHFREQUENZSCHALTKREIS UND VERFAHREN ZU DESSEN BETRIEB
CIRCUIT DE COMMUTATION RADIOFRÉQUENCE ET SON PROCÉDÉ DE FONCTIONNEMENT

(30) Priority: 19.09.2024 CN 202411306343
(43) Date of publication of application: 25.03.2026
(73) Proprietor: Getac Technology Corporation, New Taipei City 221009 (TW)
(72) Inventor: HUANG, Ching-Wei, 11568 Taipei City (TW)
(74) Representative: Viering, Jentschura & Partner mbB Patent- und Rechtsanwälte

(56) References cited:
- WO-A1-2018/017877
- US-A1- 2010 248 799
- US-A1- 2014 169 243

## Description

### BACKGROUND

### Technical Field

The present disclosure relates to a radio-frequency switching circuit and a method for operating the same. More particularly, the present disclosure relates to a radio-frequency switching circuit working effectively under radio-frequency interference and a method for operating the same.

### Description of Related Art

In electronic devices, antennas must be placed at specific locations due to chip size limitations. However, this specific location may not be suitable for receiving certain frequency bands due to the influence of nearby radio-frequency interference sources, resulting in poor user experience. For example, common problems at present include: signals from global navigation satellite systems (GNSS) such as the US's global positioning system (GPS), Russia's globalnaya navigatsionnaya sputnikovaya sistema (GLONASS), China's BeiDou navigation satellite system (BDS) and the EU's Galileo satellite navigation system (GNSS) cannot be received.

In this information age, the positioning function is likely to be used whether it is for outdoor activities (e.g., looking for an activity location) or for indoor Internet access (e.g., using the services of a delivery platform). Using a navigation system has almost become an integral part of everyone's daily life. Therefore, it is necessary to solve the above problem of being unable to receive GPSS signals due to chip specification limitations.

If the above issues are overcome by directly changing the chip specifications, it will result in high costs. Therefore, the present disclosure provides a lower cost solution.

Some known radio-frequency circuits are disclosed in WO 2018/017877 A1, US 2014/169243 A1, and US 2010/248799 A1.

### SUMMARY

A radio-frequency switching circuit is provided in the present disclosure. The radio-frequency switching circuit comprises a first antenna, a second antenna, a power divider and a frequency dividing unit. The first antenna is adjacent to a radio-frequency interference source. The second antenna is disposed outside an interfering range of the radio-frequency interference source. A first input port and a second input port of the power divider are respectively coupled with the first antenna and the second antenna. The frequency dividing unit is coupled with an output port of the power divider. The frequency dividing unit is configured to divide an integrated signal from the output port into a plurality of signal components, and wherein the radio-frequency switching circuit further comprises an amplifier. The amplifier is coupled to the frequency dividing unit, and is configured to receive and amplify one of the plurality of signal components to generate a first signal. The radio-frequency switching circuit further comprises a switching unit, a third antenna and a first signal processing unit. The switching unit is coupled to the amplifier. The third antenna is coupled to the switching unit and configured to output a second signal, wherein the third antenna is an external antenna, and the first antenna and the second antenna are internal antennas. The first signal processing unit is coupled to the switching unit, and is configured to perform signal processing on the first signal or the second signal from the switching unit. The switching unit switches to determine whether to transmit the first signal or the second signal to the first signal processing unit.

In some embodiments, the interfering range is less than a length of an electronic device where the radio-frequency switching circuit is disposed.

In some embodiments, the first antenna and the second antenna are disposed on two opposite sides of the electronic device that are separated by the length.

In some embodiments, the first antenna and the second antenna are disposed on two adjacent sides of the electronic device, and a distance between the second antenna and the radio-frequency interference source is greater than the length.

In some embodiments, the radio-frequency interference source is a connector of the electronic device, and the interfering range is determined based on the connector.

In some embodiments, the interfering range is less than 20 centimeters.

In some embodiments, the frequency dividing unit is configured to divide an integrated signal from the output port into a plurality of signal components with different frequency bands, and one of the plurality of signal components includes a global navigation system frequency band.

In some embodiments, the frequency dividing unit comprises a diplexer and an extractor. The diplexer is coupled to the output port of the power divider, and is configured to receive an integrated signal from the output port and perform a first frequency division to divide a first signal component from the integrated signal. The extractor is coupled to the diplexer, and is configured to receive the first signal component and perform a second frequency division to divide a second signal component from the first signal component.

In some embodiments, the one of the plurality of signal components includes a global navigation system frequency band, and the amplifier is a low noise amplifier.

In some embodiments, the radio-frequency switching circuit further comprises a second signal processing unit. The second signal processing unit and the first signal processing unit perform signal processing on signals of different frequency bands, wherein the switching unit comprises a first switching component and a second switching component. The switching unit is coupled to the amplifier and the third antenna through the first switching component, and coupled to the first signal processing unit and the second signal processing unit through the second switching component. The first switching component switches to determine whether to perform signal processing on the first signal or the second signal, and the second switching component switches to determine whether to use the first signal processing unit or the second signal processing unit to perform signal processing.

A method for operating the radio-frequency switching circuit is provided in the present disclosure. The method comprises: receiving a plurality of input signals by a plurality of antennas, and transmitting the plurality of input signals respectively to a plurality of input ports of a power divider; mixing the plurality of input signals into an integrated signal by the power divider, and outputting the integrated signal to a frequency dividing unit; and dividing the integrated signal into a plurality of signal components with different frequency bands by the frequency dividing unit.

**In** some embodiments, at least one input signal of the plurality of input signals does not comprise noise from a radio-frequency interference source.

**In** some embodiments, the method further comprises: determining a size of the power divider based on an internal space of an electronic device where the radio-frequency switching circuit is disposed.

In some embodiments, the dividing the integrated signal into a plurality of signal components with different frequency bands by the frequency dividing unit comprising: dividing the integrated signal into a first signal component group including a first signal component by a diplexer; and dividing the first signal component into a second signal component group including a second signal component by an extractor.

In some embodiments, the method further comprises: performing signal processing on a related signal to one of the plurality of signal components by a signal processing unit, wherein the signal comprises the signal component.

In summary, the display method disclosed herein can switch the user interface of an application from a window or a tool component to a status bar, thereby avoiding blocking the contents of other windows at the underlying layer and further improving the user experience.

### BRIEF DESCRIPTION OF THE DRAWINGS

In order to make the above and other objects, features, advantages and embodiments of the present disclosure more clearly understood, the accompanying drawings are described in the following paragraphs.
Fig. 1 is a schematic diagram of an electronic device in accordance with some embodiments of the present disclosure.
Fig. 2 is a schematic diagram of a radio-frequency switching circuit in accordance with some embodiments of the present disclosure.
Fig. 3 is a flowchart of a method for operating a radio-frequency switching circuit in accordance with some embodiments of the present disclosure.
Fig. 4 is a flowchart of further details of operation 340 in Fig. 3 in accordance with some embodiments of the present disclosure.

### DETAILED DESCRIPTION

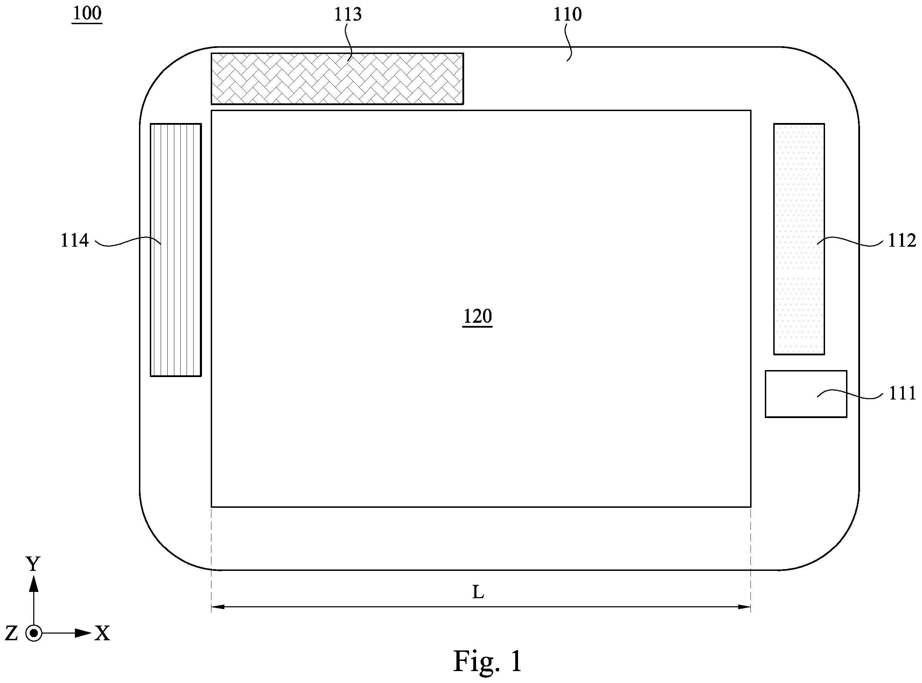

Please refer to Fig. 1. Fig. 1 is a schematic diagram of an electronic device 100 in accordance with some embodiments of the present disclosure. As shown in Fig. 1, the electronic device 100 comprises an edge 110 and a body 120. Specifically, the electronic device 100 may be a tablet computer, a notebook computer, a desktop computer, a car computer, a mobile phone, a game console, etc. The edge 110 comprises spaces 111-114. The electronic device 100 extends along a direction X and a direction Y. The direction X and the direction Y are perpendicular to each other.

In the direction X, each of the spaces 111 and 112 is located at one side of the body 120, and the space 114 is located at the other side of the body 120. The space 113 is located at one side of the body 120 in the direction Y. The spaces 111-114 may be configured to accommodate antennas or connectors, wherein the connector may be a USB connector, an HDMI connector, an HML connector, a displayPort connector, a thunderbolt connector, etc. In other words, in some embodiments, the size of the edge 110 is at least larger than the size of the antenna and/or the connector so that the antenna and/or the connector can be placed in the spaces 111-114. When the connector is transmitting data, it will cause radio-frequency interference to the signal received by the antenna near the connector.

For example, when a USB connector is transmitting data, the antenna near the USB connector may have poor signal reception quality or may even fail to receive a signal at a specific frequency band, such as the GPS L1 frequency band (1575.42±30.69 MHz). Therefore, the USB connector that is performing data transmission can be regarded as a radio-frequency interference source, and the USB connector is also one of the most common radio-frequency interference sources of the electronic device 100. For another example, a USB connector is disposed in the space 111 and an antenna is disposed in the space 112 adjacent to the space 111. When the USB connector in the space 111 is performing data transmission, the signal reception of the antenna in the space 112 will be disturbed.

However, when the antenna is outside an interfering range of the radio-frequency interference source, the signal reception of the antenna is considered to be unaffected by the radio-frequency interference source. In some embodiments, the radio-frequency interfering range is determined based on a signal-to-noise ratio (SNR). For example, as the antenna moves outward from the center of the radio-frequency interference source, the SNR will gradually increase. When the SNR is equal to 20dB, the distance between the antenna and the center of the interference source is considered the interfering range.

In some embodiments, the radio-frequency interfering range is determined based on a carrier-to-noise ratio (CN value). For example, as the antenna moves outward from the center of the radio-frequency interference source, the CN value will gradually increase. When the CN value is 30dB, the distance between the antenna and the center of the interference source is considered the interfering range. In some embodiments, when the distance between the antenna and the center of the radio-frequency interference source is about 15 centimeters, the CN value is about 30 dB, and when the distance between the antenna and the center of the radio-frequency interference source is less than 1.5 centimeters, the CN value is almost zero. Therefore, it can take 15 centimeters as the interfering range.

In some embodiments, the interfering range is determined based on the type of radio-frequency interference source. Specifically, when the radio-frequency interference source is a USB connector, an HDMI connector, an HML connector, a displayPort connector or a thunderbolt connector, the interfering range may be less than 15 centimeters. In some embodiments, in addition to the connector, the interfering range is also determined based on the adapter cable and the control cable.

In addition, the length L of a common tablet computer is about 7-12.9 inches, i.e., 17.8-32.8 centimeters. The length L of a common laptop is about 10-17 inches, or 25.4-43.2 centimeters. The length L of a common desktop computer host is about 24-30 centimeters. In the present disclosure, the length L is the length of the electronic device 100 excluding the edge 110, which is approximately the vertical distance between the space 112 and the space 114. In other words, the interfering range may be less than the length L of the tablet computer, the notebook computer and the desktop computer. Therefore, at least for tablet computers, notebook computers and desktop computers, another antenna can be set up to receive signals in the above-mentioned specific frequency band, so as to compensate for the shortcomings of the antenna disposed in the space 112.

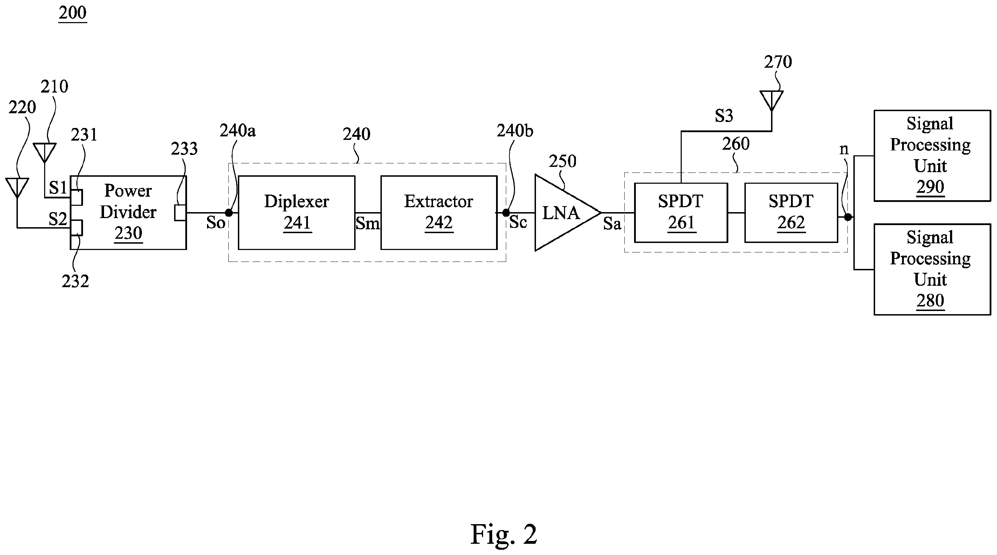

Please refer to Fig. 1 and Fig. 2 together. Fig. 2 is a schematic diagram of a radio-frequency switching circuit 200 in accordance with some embodiments of the present disclosure. In some embodiments, the radio-frequency switching circuit 200 is disposed in the electronic device 100. As shown in Fig. 2, the radio-frequency switching circuit 200 comprises an antenna 210, an antenna 220, a power divider 230 and a frequency dividing unit 240. The antenna 210 is adjacent to a radio-frequency interference source rfo (not shown in drawings). In other words, the antenna 210 is the antenna that is most affected by the radio-frequency interference source rfo in the radio-frequency switching circuit 200. In some embodiments, the antenna 210 is determined based on the CN value. Specifically, the antenna with the smallest CN value is used as the antenna 210. In some embodiments, in the absence of a radio-frequency shield, the antenna closest to the radio-frequency interference source rfo in the radio-frequency switching circuit 200 is used as the antenna 210.

In some embodiments, as described above, the antenna 210 and the radio-frequency interference source rfo are disposed in two adjacent spaces 111 and 112 where antennas or connectors are accommodated, as shown in Fig. 1. Specifically, the antenna 210 is disposed in the space 111, and the radio-frequency interference source rfo is disposed in the space 112. For the ease of explanation, this configuration is often used as an example in the following paragraphs, but it is not intended to limit the present disclosure. In some embodiments, the radio-frequency interference source rfo may be disposed outside the electronic device 100. The radio-frequency interference source rfo is not limited to a connector. In some embodiments, the radio-frequency interference source rfo may be a base station, a radio device or a wireless transmitter.

The antenna 220 is disposed outside the interfering range of the radio-frequency interference source rfo. As a result, unlike the antenna 210, the antenna 220 is not or is hardly affected by the radio-frequency interference source rfo, and thus can be used as an auxiliary antenna for receiving the interfered frequency band. In some embodiments, antenna 220 is disposed in the space 114. In other words, the antenna 210 and the antenna 220 are disposed on two opposite sides of the electronic device 100 separated by the length L. In some embodiments, the antenna 220 is disposed in the space 113. In other words, the antenna 210 and the antenna 220 are disposed on two adjacent sides of the electronic device 100, and as shown in Fig. 1, when the antenna 210 is disposed on the right side of the electronic device 100, the antenna 220 is close to the upper left corner of the electronic device 100 (conversely, when the antenna 210 is disposed on the left side of the electronic device 100, the antenna 220 is close to the upper right corner of the electronic device 100). Thereby, the distance between the antenna 220 and the radio-frequency interference source rfo disposed in the space 111 can be greater than the length **L,** so as to avoid radio-frequency interference.

The power divider 230 includes an input port 231, an input port 232 and an output port 233. As shown in Fig. 2, the input port 231 is coupled to the antenna 210 and configured to receive an input signal S1 from the antenna 210. The input port 232 is coupled to the antenna 220 and configured to receive an input signal S2 from the antenna 220. Specifically, taking the reception of GPS signals as an example, the antenna 210 receives the GPS signals and the noise RFno of the radio-frequency interference source rfo, and the antenna 220 receives the GPS signals but does not receive the noise RFno. In some embodiments, the antenna 210 and the antenna 220 also receive signals in other frequency bands.

For example, the antenna 210 and the antenna 220 receive signals in a low frequency band (L-band), a mid-frequency band (M-band), a high frequency band (H-band) and/or an ultra-high frequency band (UH-band). Among them, the frequency range of L-band is 698-960 MHz; the frequency range of M-band is 1427-960 MHz; the frequency range of H-band is 1710-2690 MHz; and the frequency range of UH-band is 3400-3600 MHz, 3600-3800 MHz and 5150-5850 MHz. The GPS frequency bands include L1 band (1575.42±30.69 MHz) and L5 band (1176.60±1.023 MHz).

Therefore, the signal S1 includes the GPS signal and the noise RFno, while the signal S2 includes the GPS signal but does not include the noise RFno. After the antenna 210 and the antenna 220 receive the signals S1 and S2, the antenna 210 and the antenna 220 transmit the signals S1 and S2 respectively to the input port 231 and the input port 232. In this way, the power divider 230 can mix the signal S1 and the signal S2 into an integrated signal So, and output the integrated signal So to the output port 233.

In some methods, the input port 231 and the input port 232 are configured to output signals, and the output port 233 is configured to input signals, which is called the forward operation of the power divider 230. In the forward operation, the power divider 230 is configured to divide the power of an input signal into two output parts. However, in the above-mentioned embodiment of the present disclosure, the configuration of the power divider 230 corresponds to a reverse operation opposite to the forward operation. In the reverse operation, the power divider 230 is configured to combine the power of two signals and output them. The power divider 230 operating in the reverse operation is also called a power combiner.

Furthermore, in some embodiments, in addition to the input port 231 and the input port 232, the power divider 230 may further include other input ports. In other words, a multi-way power divider other than the two-way power divider, such as a three-way power divider, a four-way power divider, an eight-way power divider, etc., can be used as the power distributor 230. The number of input ports of the power divider 230 can be determined based on usage requirements. For example, BDS has the advantage of SMS communication over GPS. If one wants to use the GPS positioning and SMS communication functions, in addition to the two antennas for receiving GPS, a third antenna needs to be added to the radio-frequency switching circuit 200 to receive BDS signals. Accordingly, the power divider 230 is a three-way power divider.

The frequency dividing unit 240 is coupled to the output port 233 of the power divider 230, so as to receive the integrated signal So and divide the integrated signal So to filter out the desired signal, such as a GPS signal. In some methods, the radio-frequency switching circuit on the chip comprises only a single antenna 210, and the antenna 210 directly transmits the received signal S1 to the input terminal 240a of the frequency dividing unit 240 for frequency division. In other words, the input terminal 240a of the frequency dividing unit 240 serves as the only input port for the antenna signal.

However, as described above, the radio-frequency switching circuit 200 of the present disclosure may include two input ports for antenna signal, i.e., the input ports 231 and 232 of the power divider 230, by introducing the power divider 230. Therefore, in addition to the antenna 210, a new antenna 220 may be disposed in the radio-frequency switching circuit 200. In addition, the power divider 230 is coupled between the two antennas and the input terminal 240a of the frequency dividing unit 240, so that the signals S1 and S2 of the two antennas can be integrated into an integrated signal So, and then the integrated signal So is also transmitted to the input terminal 240a of the frequency dividing unit 240 on the chip. In this way, there is no need to change the chip specifications. The aforementioned radio-frequency interference problem can be solved by simply placing the newly added antenna 220 outside the interfering range, and the antenna 210 can still be configured to receive other frequency bands outside the interfered frequency band.

Furthermore, in some embodiments, the frequency dividing unit 240 divides the integrated signal So into a plurality of signal components including different frequency bands, such as L-band, M-band, H-band and UH-band. These signal components include the signal component Sc outputted from the output terminal 240b of the frequency dividing unit 240. In some embodiments, the frequency band of one of these signal components is a GNSS frequency band, such as a GPS frequency band. In some embodiments, the frequency band of one of these signal components is a GPS L1 frequency band.

Specifically, in some embodiments, the frequency dividing unit 240 comprises a diplexer 241 and an extractor 242. The diplexer 241 and the extractor 242 are coupled in series between the input terminal 240a and the output terminal 240b. As shown in Fig. 2, one terminal of the diplexer 241 is coupled to the output port 233 of the power divider 230 at the input terminal 240a, and the other terminal of the diplexer 241 is coupled to the extractor 242. In addition, the diplexer 241 is configured to receive the integrated signal So from the output port 233 and perform a first frequency division to divide a signal component Sm from the integrated signal So. In some embodiments, the diplexer 241 filters out the signal components including the UH-band, and thus the remaining signal component Sm is transmitted to the extractor 242.

In addition, the extractor 242 is configured to receive the signal component Sm and perform a second frequency division to divide the signal component Sc from the signal component Sm. In some embodiments, the diplexer 241 filters out the signal components including the L-band, the M-band and the H-band, and thus the remaining signal component Sc is transmitted to an amplifier 250.

In other words, the frequency divisions performed by the frequency dividing unit 240 comprising the diplexer 241 and the extractor 242 includes the first frequency division and the second frequency division. In some embodiments, the signal including UH-band is filtered out in the first frequency division, and the signal components including L-band, M-band and H-band are filtered out in the second frequency division. Then, the remaining signal component Sc is transmitted to the input terminal of the amplifier 250. In some embodiments, the signal component Sc includes a GPS L1 frequency band.

Furthermore, the radio-frequency switching circuit 200 further comprises an amplifier 250. The amplifier 250 is coupled to the output terminal 240b of the frequency dividing unit 240 and configured to receive the signal component Sc. When the signal component Sc is not strong enough, the signal component Sc needs to be amplified by the amplifier 250 to generate a strong enough signal Sa. The type of amplifier 250 can be determined based on usage requirements. In some embodiments, as shown in Fig. 2, the amplifier 250 is a low noise amplifier (LNA). Regarding the current problem of radio-frequency interference of GPS signals, using LNA can avoid excessive noise after GPS signals are amplified. In other words, when the signal component Sc output by the frequency dividing unit 240 is a GNSS signal, such as a GPS signal, an LNA may be used as the amplifier 250 to minimize the influence of noise.

In addition, the radio-frequency switching circuit 200 further comprises a switching unit 260, an antenna 270 and a signal processing unit 280. As shown in Fig. 2, the switching unit 260 is coupled to the output terminal 240b of the amplifier 250, the antenna 270 and the signal processing unit 280. The antenna 270 is configured to output a signal S3. In some embodiments, a frequency dividing unit (not shown in drawings) different from the frequency dividing unit 240 is coupled between the antenna 270 and the switching unit 260, so as to extract a signal component including a specific frequency band from the signal S3 and send it to the switching unit 260.

As also shown in Fig. 2, the switching unit 260 is configured to receive the signal Sa and the signal S3. Specifically, in some embodiments, the switching unit 260 may be a single pole double throw (SPDT) switch. The switching unit 260 switches to determine whether to transmit the signal Sa or the signal S3 to the signal processing unit 280. In some embodiments, the switching unit 260 is connected to the amplifier 250 and the signal processing unit 280. Accordingly, the switching unit 260 disconnects the connection between the antenna 270 and the signal processing unit 280. Therefore, the signal Sa is transmitted to the signal processing unit 280. In some embodiments, the switching unit 260 is connected to the antenna 270 and the signal processing unit 280. Accordingly, the switching unit 260 disconnects the connection between the amplifier 250 and the signal processing unit 280. Therefore, the signal S3 is transmitted to the signal processing unit 280.

In some embodiments, the antenna 270 is an external antenna, and antennas 210 and 220 are internal antennas. The external antenna refers to a removable antenna disposed outside the electronic device 100. On the contrary, the internal antenna refers to an internal clamp-on antenna disposed in the electronic device 100. Since the internal antennas of mobile devices, such as mobile phones and tablet computers, are usually small and easily affected by the surrounding environment, an external antenna is needed as a backup antenna to maintain the signal strength and stability. Under the above-mentioned configuration of the switching unit 260, when the internal antennas 210 and 220 receive signals well, signals are received by the internal antennas 210 and 220 continuously. When the internal antennas 210 and 220 receive signals poorly, the external antenna 270 may receive signals instead.

In addition, the signal processing unit 280 is configured to perform signal processing on the signal Sa or the signal S3 from the switching unit 260. Signal processing can include extracting, analyzing or computing signals.

In some examples not having all features of claim 1, the amplifier 250, the switching unit 260 and the antenna 270 may be omitted, and the frequency dividing unit 240 is directly coupled to the signal processing unit 280. In other words, the signal component Sc is directly transmitted to the signal processing unit 280. This configuration is suitable for the case where the signal component Sc is strong enough.

In some embodiments, the radio-frequency switching circuit 200 further comprises a signal processing unit 290, and the switching unit 260 comprises a switching component 261 and a switching component 262. In some embodiments, the signal processing unit 290 and the signal processing unit 280 are configured to perform different signal processing. For example, the signal processing unit 280 is configured to extract the signal, and the signal processing unit 280 is configured to perform operations on the signal. In some embodiments, the signal processing unit 290 and the signal processing unit 280 are configured to perform signal processing on signals including different frequency bands. For example, the signal processing unit 280 is configured to process signals including the GPS L1 frequency band, and the signal processing unit 290 is configured to process signals including the GPS L5 frequency band.

In addition, as shown in Fig. 2, the switching component 261 and the switching component 262 are coupled in series between the output terminal of the amplifier 250 and a node n. Specifically, the switching component 261 is coupled to the amplifier 250 and the antenna 270. The switching component 262 is coupled to the signal processing unit 280 and the signal processing unit 290 at the node n. In other words, the switching unit 260 is coupled to the amplifier 250 and the antenna 270 through the switching component 261, and coupled to the signal processing unit 280 and the signal processing unit 290 through the switching component 262. In some embodiments, each of the switching component 261 and the switching component 262 may be implemented by a SPDT.

The switching component 261 switches to determine whether to process the signal Sa or the signal S3. In some embodiments, the switching component 261 is connected to the amplifier 250 and the switching component 262. Accordingly, the switching component 261 disconnects the connection between the antenna 270 and the switching component 262. Therefore, the signal Sa is transmitted to the switching component 262. In some embodiments, the switching component 261 is connected to the antenna 270 and the switching component 262. Accordingly, the switching component 261 disconnects the connection between the amplifier 250 and the switching component 262. Therefore, the signal S3 is transmitted to the switching component 262.

The switching component 262 switches to determine whether to use the signal processing unit 280 or the signal processing unit 290 to perform signal processing. In some embodiments, the switching component 262 is connected to the switching component 261 and the signal processing unit 280. Accordingly, the switching component 262 disconnects the connection between the switching component 261 and the signal processing unit 290. Therefore, the switching component 262 transmits the signal Sa or the signal S3 from the switching component 261 to the signal processing unit 280, so that the signal processing unit 280 performs signal processing. In some embodiments, The switching component 262 is connected to the switching component 261 and the signal processing unit 290. Accordingly, the switching component 262 disconnects the connection between the switching component 261 and the signal processing unit 280. Therefore, the switching component 262 transmits the signal Sa or the signal S3 from the switching component to the signal processing unit 290, so that the signal processing unit 290 performs signal processing.

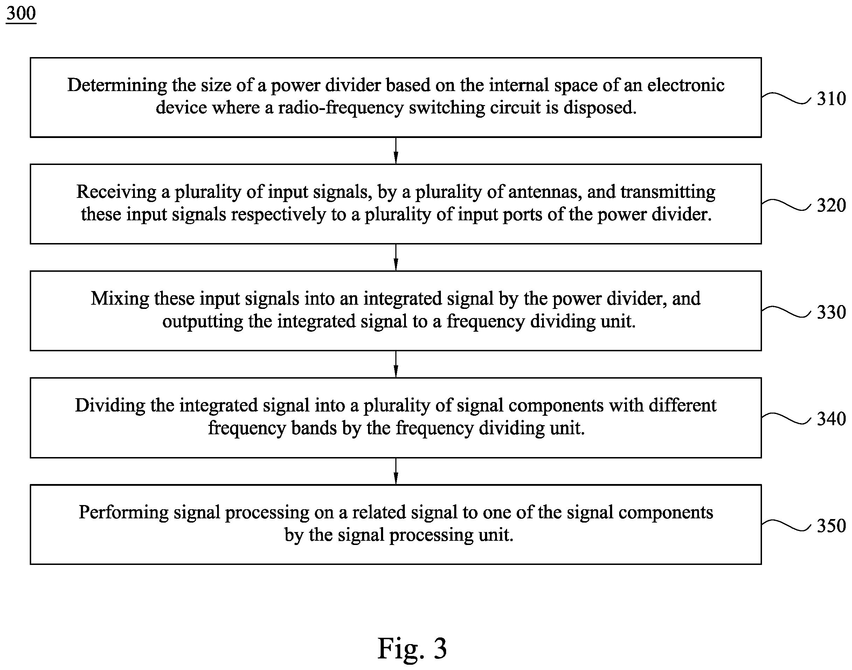

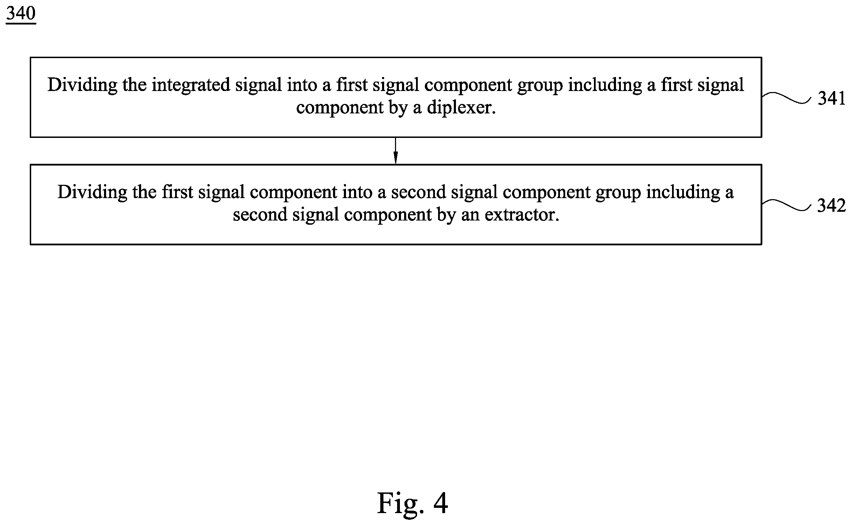

Please refer to Figs. 2, 3 and 4 together. Fig. 3 is a flowchart of a method 300 for operating the radio-frequency switching circuit 200 in accordance with some embodiments of the present disclosure. Fig. 4 is a flowchart of operation 340 of Fig. 3 in accordance with some embodiments of the present disclosure. It should be understood that additional operations may be provided before, during and after the processes shown in Fig. 3, and that some operations described below may be replaced or eliminated for additional embodiments of the method. The order of operations/processes may be interchangeable. In the various drawings and illustrative embodiments, the same reference numerals are used to represent the same elements. The method 300 comprises the following operations 310, 320, 330, 340 and 350 with reference to Fig. 3.

In operation 310, the size of the power divider 230 is determined based on the internal space of the electronic device 100 where the radio-frequency switching circuit 200 is disposed. Specifically, an experiment is first conducted using an external power divider to confirm that the preset configuration of the radio-frequency switching circuit 200, such as the configuration of the position of the antenna 220 for achieving a good signal reception effect. Next, the power divider 230 that can be clamped into the electronic device 100 is manufactured based on the internal space of the electronic device 100. This can avoid cost waste caused by the preset configuration not meeting expectations. In addition, the basis for judging whether the preset configuration of the radio-frequency switching circuit 200 obtains a good signal reception effect may include but is not limited to return loss, insertion loss and isolation.

In operation 320, the antennas 210 and 220 receive input signals S1 and S2, and transmit the input signals S1 and S2 respectively to the input ports 231 and 232 of the power divider 230. In addition, the input signal S1 and/or the input signal S2 does not include the noise of the radio-frequency interference source rfo.

**In** operation 330, the power divider 230 further mixes the input signals S1 and S2 into an integrated signal So, and outputs the integrated signal So to the frequency dividing unit 240.

**In** operation 340, the frequency dividing unit 240 further divides the integrated signal So into a plurality of signal components including different frequency bands, such as L-band, M-band, H-band and UH-band. **In** some embodiments, operation 340 comprises sub-operation 341 and sub-operation 342.

As shown in Fig. 4, in the sub-operation 341, the diplexer 241 divides the integrated signal So into a first signal component group including the signal component Sm. In some embodiments, the first signal component group further includes a signal component including the UH-band. In the sub-operation 342, the signal component Sm is further divided into a second signal component group including the signal component Sc by the extractor 242. In some embodiments, the second signal component group further includes signal components including the L-band, the M-band and the H-band.

In operation 350, the signal processing unit 280 performs signal processing on a related signal to the signal component Sc of the signal components. Specifically, this related signal is a signal transmitted to the node n. In some embodiments, this related signal is an amplified signal of the signal component Sc amplified by the amplifier 250. In some embodiments, the amplifier 250, the switching unit 260 and the antenna 270 are omitted, and this related signal may be the signal component Sc. In other words, this related signal includes the signal component Sc.

In summary, by adding an antenna outside the interfering range, the radio-frequency switching circuit 200 and method 300 for operating the same disclosed in the present disclosure solve the radio-frequency interference problem due to the chip specification limitation.

## Claims

1. A radio-frequency switching circuit (200), comprising:
a first antenna (210), adjacent to a radio-frequency interference source;
a second antenna (220), disposed outside an interfering range of the radio-frequency interference source;
a power divider (230), wherein a first input port (231) and a second input port (232) of the power divider are respectively coupled with the first antenna and the second antenna; and
a frequency dividing unit (240), coupled with an output port (233) of the power divider;
wherein the frequency dividing unit is configured to divide an integrated signal (So) from the output port into a plurality of signal components (Sm, Sc), and wherein the radio-frequency switching circuit further comprises:
an amplifier (250), coupled to the frequency dividing unit, and configured to receive and amplify one of the plurality of signal components to generate a first signal (Sa);
wherein the radio-frequency switching circuit further comprises:
a switching unit (260), coupled to the amplifier;
a third antenna (270), coupled to the switching unit and configured to output a second signal (S3), wherein the third antenna is an external antenna, and the first antenna and the second antenna are internal antennas; and
a first signal processing unit (280), coupled to the switching unit, and configured to perform signal processing on the first signal or the second signal from the switching unit,
wherein the switching unit switches to determine whether to transmit the first signal or the second signal to the first signal processing unit.

2. The radio-frequency switching circuit of claim 1, wherein the interfering range is less than a length (L) of an electronic device (100) where the radio-frequency switching circuit is disposed.

3. The radio-frequency switching circuit of claim 2, wherein the first antenna and the second antenna are disposed on two opposite sides (111 & 114) of the electronic device that are separated by the length.

4. The radio-frequency switching circuit of claim 2, wherein the first antenna and the second antenna are disposed on two adjacent sides (111 & 113) of the electronic device, and a distance between the second antenna and the radio-frequency interference source is greater than the length.

5. The radio-frequency switching circuit of any one of claims 2-4, wherein the radio-frequency interference source is a connector of the electronic device, and the interfering range is determined based on the connector.

6. The radio-frequency switching circuit of any one of claims 1-5, wherein the frequency dividing unit is configured to divide an integrated signal (So) from the output port into a plurality of signal components (Sc) with different frequency bands, and one of the plurality of signal components includes a global navigation system frequency band.

7. The radio-frequency switching circuit of any one of claims 1-5, wherein the frequency dividing unit comprises:
a diplexer (241), coupled to the output port of the power divider, and configured to receive an integrated signal (So) from the output port and perform a first frequency division to divide a first signal component (Sm) from the integrated signal; and
an extractor (242), coupled to the diplexer, and configured to receive the first signal component and perform a second frequency division to divide a second signal component (Sc) from the first signal component.

8. The radio-frequency switching circuit of any one of claims 1 to 7, wherein the one of the plurality of signal components includes a global navigation system frequency band, and the amplifier is a low noise amplifier.

9. The radio-frequency switching circuit of any one of claims 1 to 8, further comprising:
a second signal processing unit (290), wherein the second signal processing unit and the first signal processing unit perform signal processing on signals of different frequency bands, wherein the switching unit comprises a first switching component (261) and a second switching component (262),
wherein the switching unit is coupled to the amplifier and the third antenna through the first switching component, and coupled to the first signal processing unit and the second signal processing unit through the second switching component,
wherein the first switching component switches to determine whether to perform signal processing on the first signal or the second signal, and
the second switching component switches to determine whether to use the first signal processing unit or the second signal processing unit to perform signal processing.

10. A method (300) of operating the radio-frequency switching circuit (200) according to any one of claims 1 to 9, wherein the method comprises:
(320) receiving a plurality of input signals, by a plurality of antennas (210, 220), and transmitting the plurality of input signals respectively to a plurality of input ports (231, 232) of a power divider (230);
(330) mixing the plurality of input signals into an integrated signal (So) by the power divider, and outputting the integrated signal to a frequency dividing unit (240); and
(340) dividing the integrated signal into a plurality of signal components (Sm, Sc) with different frequency bands by the frequency dividing unit.

11. The method of claim 10, further comprising:
determining a size of the power divider based on an internal space of an electronic device (100) where the radio-frequency switching circuit is disposed.

12. The method of claim 10 or claim 11, wherein the dividing the integrated signal into a plurality of signal components with different frequency bands by the frequency dividing unit comprises:
(341) dividing the integrated signal into a first signal component group including a first signal component (Sm) by a diplexer (241); and
(342) dividing the first signal component into a second signal component group including a second signal component (Sc) by an extractor (242).

13. The method of any one of claims 10, 11 and 12, further comprising:
(350) performing signal processing on a related signal to one of the plurality of signal components by a signal processing unit (280), wherein the related signal comprises the signal component.

## Patentansprüche

1. Radiofrequenz-Schalterschaltung (200), aufweisend:
eine erste Antenne (210) benachbart zu einer Radiofrequenz-Störquelle,
eine zweite Antenne (220), die außerhalb eines Störbereichs der Radiofrequenz-Störquelle angeordnet ist,
einen Leistungsteiler (230), wobei ein erster Eingangsanschluss (231) und ein zweiter Eingangsanschluss (232) des Leistungsteilers jeweils mit der ersten Antenne und der zweiten Antenne gekoppelt sind, und
eine Frequenzteilereinheit (240), die mit einem Ausgangsanschluss (233) des Leistungsteilers gekoppelt ist,
wobei die Frequenzteilereinheit konfiguriert ist, um ein integriertes Signal (So) vom Ausgangsanschluss in eine Mehrzahl von Signalkomponenten (Sm, Sc) zu teilen, und wobei die Radiofrequenz-Schalterschaltung ferner aufweist:
einen Verstärker (250), der mit der Frequenzteilereinheit gekoppelt ist und konfiguriert ist, um eine aus der Mehrzahl von Signalkomponenten zu empfangen und zu verstärken, um ein erstes Signal (Sa) zu erzeugen,
wobei die Radiofrequenz-Schalterschaltung ferner aufweist:
eine Schalteinheit (260), die mit dem Verstärker gekoppelt ist,
eine dritte Antenne (270), die mit der Schalteinheit gekoppelt ist und konfiguriert ist, um ein zweites Signal (S3) auszugeben, wobei die dritte Antenne eine externe Antenne ist und die erste Antenne und die zweite Antenne interne Antennen sind, und
eine erste Signalverarbeitungseinheit (280), die mit der Schalteinheit gekoppelt ist und konfiguriert ist, um eine Signalverarbeitung am ersten Signal oder am zweiten Signal von der Schalteinheit durchzuführen,
wobei die Schalteinheit schaltet, um zu ermitteln, ob das erste Signal oder das zweite Signal an die erste Signalverarbeitungseinheit zu übermitteln ist.

2. Radiofrequenz-Schalterschaltung gemäß Anspruch 1, wobei der Störbereich kleiner als eine Länge (L) einer elektronischen Vorrichtung (100) ist, wo die Radiofrequenz-Schalterschaltung angeordnet ist.

3. Radiofrequenz-Schalterschaltung gemäß Anspruch 2, wobei die erste Antenne und die zweite Antenne an zwei gegenüberliegenden Seiten (111 & 114) der elektronischen Vorrichtung angeordnet sind, die durch die Länge voneinander getrennt sind.

4. Radiofrequenz-Schalterschaltung gemäß Anspruch 2, wobei die erste Antenne und die zweite Antenne an zwei benachbarten Seiten (111 & 113) der elektronischen Vorrichtung angeordnet sind und ein Abstand zwischen der zweiten Antenne und der Radiofrequenz-Störquelle größer als die Länge ist.

5. Radiofrequenz-Schalterschaltung gemäß irgendeinem der Ansprüche 2 bis 4, wobei die Radiofrequenz-Störquelle ein Anschlussstück der elektronischen Vorrichtung ist und der Störbereich basierend auf dem Anschlussstück ermittelt wird.

6. Radiofrequenz-Schalterschaltung gemäß irgendeinem der Ansprüche 1 bis 5, wobei die Frequenzteilereinheit konfiguriert ist, um ein integriertes Signal (So) vom Ausgangsanschluss in eine Mehrzahl von Signalkomponenten (Sc) mit unterschiedlichen Frequenzbändern aufzuteilen, und eine aus der Mehrzahl von Signalkomponenten ein Globales-Navigationssystem-Frequenzband aufweist.

7. Radiofrequenz-Schalterschaltung gemäß irgendeinem der Ansprüche 1 bis 5, wobei die Frequenzteilereinheit aufweist:
einen Diplexer (241), der mit dem Ausgangsanschluss des Leistungsteilers gekoppelt ist und konfiguriert ist, um ein integriertes Signal (So) vom Ausgangsanschluss zu empfangen und eine erste Frequenzteilung durchzuführen, um eine erste Signalkomponente (Sm) von dem integrierten Signal zu teilen, und
einen Extraktor (242), der mit dem Diplexer gekoppelt ist und konfiguriert ist, um die erste Signalkomponente zu empfangen und eine zweite Frequenzteilung durchzuführen, um eine zweite Signalkomponente (Sc) von der ersten Signalkomponente zu teilen.

8. Radiofrequenz-Schalterschaltung gemäß irgendeinem der Ansprüche 1 bis 7, wobei die eine aus der Mehrzahl von Signalkomponenten ein Globales-Navigationssystem-Frequenzband aufweist und der Verstärker ein rauscharmer Verstärker ist.

9. Radiofrequenz-Schalterschaltung gemäß irgendeinem der Ansprüche 1 bis 8, ferner aufweisend:
eine zweite Signalverarbeitungseinheit (290), wobei die zweite Signalverarbeitungseinheit und die erste Signalverarbeitungseinheit eine Signalverarbeitung an Signalen verschiedener Frequenzbänder durchführen, wobei die Schalteinheit eine erste Schaltkomponente (261) und eine zweite Schaltkomponente (262) aufweist,
wobei die Schalteinheit über die erste Schaltkomponente mit dem Verstärker und der dritten Antenne gekoppelt ist und über die zweite Schaltkomponente mit der ersten Signalverarbeitungseinheit und der zweiten Signalverarbeitungseinheit gekoppelt ist,
wobei die erste Schaltkomponente schaltet, um zu ermitteln, ob eine Signalverarbeitung am ersten Signal oder am zweiten Signal durchzuführen ist, und
die zweite Schaltkomponente schaltet, um zu ermitteln, ob die erste Signalverarbeitungseinheit oder die zweite Signalverarbeitungseinheit zur Durchführung der Signalverarbeitung zu verwenden ist.

10. Verfahren (300) zum Betreiben der Radiofrequenz-Schalterschaltung (200) gemäß irgendeinem der Ansprüche 1 bis 9, wobei das Verfahren aufweist:
(320) Empfangen einer Mehrzahl von Eingangssignalen durch eine Mehrzahl von Antennen (210, 220) und Übermitteln der Mehrzahl von Eingangssignalen jeweils an eine Mehrzahl von Eingangsanschlüssen (231, 232) eines Leistungsteilers (230),
(330) Mischen der Mehrzahl von Eingangssignalen zu einem integrierten Signal (So) durch den Leistungsteiler und Ausgeben des integrierten Signals an eine Frequenzteilereinheit (240), und
(340) Teilen des integrierten Signals in eine Mehrzahl von Signalkomponenten (Sm, Sc) mit unterschiedlichen Frequenzbändern durch die Frequenzteilereinheit.

11. Verfahren gemäß Anspruch 10, ferner aufweisend:
Ermitteln einer Größe des Leistungsteilers basierend auf einem Innenraum einer elektronischen Vorrichtung (100), wo die Radiofrequenz-Schalterschaltung angeordnet ist.

12. Verfahren gemäß Anspruch 10 oder Anspruch 11, wobei das Teilen des integrierten Signals in eine Mehrzahl von Signalkomponenten mit unterschiedlichen Frequenzbändern durch die Frequenzteilereinheit aufweist:
(341) Teilen des integrierten Signals in eine erste Signalkomponentengruppe, die eine erste Signalkomponente (Sm) aufweist, durch einen Diplexer (241), und
(342) Teilen der ersten Signalkomponente in eine zweite Signalkomponentengruppe, die eine zweite Signalkomponente (Sc) aufweist, durch einen Extraktor (242).

13. Verfahren gemäß irgendeinem der Ansprüche 10, 11 und 12, ferner aufweisend:
(350) Durchführen einer Signalverarbeitung an einem bezogenen Signal in eine der Mehrzahl von Signalkomponenten durch eine Signalverarbeitungseinheit (280), wobei das bezogene Signal die Signalkomponente aufweist.

## Revendications

1. Circuit de commutation radiofréquence (200), comprenant :
une première antenne (210), adjacente à une source d'interférence radiofréquence ;
une deuxième antenne (220), disposée en dehors d'une portée d'interférence de la source d'interférence radiofréquence ;
un diviseur de puissance (230), dans lequel un premier port d'entrée (231) et un deuxième port d'entrée (232) du diviseur de puissance sont respectivement couplés à la première antenne et à la deuxième antenne ; et
une unité de division de fréquence (240), couplée à un port de sortie (233) du diviseur de puissance ;
dans lequel l'unité de division de fréquence est configurée pour diviser un signal intégré (So) provenant du port de sortie en une pluralité de composantes de signal (Sm, Sc), et dans lequel le circuit de commutation radiofréquence comprend en outre :
un amplificateur (250), couplé à l'unité de division de fréquence, et configuré pour recevoir et amplifier l'une de la pluralité de composantes de signal afin de générer un premier signal (Sa) ;
dans lequel le circuit de commutation radiofréquence comprend en outre :
une unité de commutation (260), couplée à l'amplificateur ;
une troisième antenne (270), couplée à l'unité de commutation et configurée pour émettre un deuxième signal (S3), dans lequel la troisième antenne est une antenne externe, et la première antenne et la deuxième antenne sont des antennes internes ; et
une première unité de traitement de signal (280), couplée à l'unité de commutation, et configurée pour effectuer un traitement de signal sur le premier signal ou le deuxième signal provenant de l'unité de commutation,
dans lequel l'unité de commutation effectue une commutation pour déterminer s'il faut transmettre le premier signal ou le deuxième signal à la première unité de traitement de signal.

2. Circuit de commutation radiofréquence selon la revendication 1, dans lequel la portée d'interférence est inférieure à une longueur (L) d'un dispositif électronique (100) où est disposé le circuit de commutation radiofréquence.

3. Circuit de commutation radiofréquence selon la revendication 2, dans lequel la première antenne et la deuxième antenne sont disposées sur deux côtés opposés (111 et 114) du dispositif électronique, séparés par ladite longueur.

4. Circuit de commutation radiofréquence selon la revendication 2, dans lequel la première antenne et la deuxième antenne sont disposées sur deux côtés adjacents (111 et 113) du dispositif électronique, et une distance entre la deuxième antenne et la source d'interférence radiofréquence est supérieure à ladite longueur.

5. Circuit de commutation radiofréquence selon l'une quelconque des revendications 2 à 4, dans lequel la source d'interférence radiofréquence est un connecteur du dispositif électronique, et la portée d'interférence est déterminée sur la base du connecteur.

6. Circuit de commutation radiofréquence selon l'une quelconque des revendications 1 à 5, dans lequel l'unité de division de fréquence est configurée pour diviser un signal intégré (So) provenant du port de sortie en une pluralité de composantes de signal (Sc) ayant des bandes de fréquences différentes, et l'une de la pluralité de composantes de signal comprend une bande de fréquences de système de navigation global.

7. Circuit de commutation radiofréquence selon l'une quelconque des revendications 1 à 5, dans lequel l'unité de division de fréquence comprend :
un diplexeur (241), couplé au port de sortie du diviseur de puissance, et configuré pour recevoir un signal intégré (So) provenant du port de sortie et effectuer une première division de fréquence afin de diviser une première composante de signal (Sm) du signal intégré ; et
un extracteur (242), couplé au diplexeur, et configuré pour recevoir la première composante de signal et effectuer une deuxième division de fréquence afin de diviser une deuxième composante de signal (Sc) de la première composante de signal.

8. Circuit de commutation radiofréquence selon l'une quelconque des revendications 1 à 7, dans lequel ladite une de la pluralité de composantes de signal comprend une bande de fréquences de système de navigation global, et l'amplificateur est un amplificateur à faible bruit.

9. Circuit de commutation radiofréquence selon l'une quelconque des revendications 1 à 8, comprenant en outre :
une deuxième unité de traitement de signal (290), dans lequel la deuxième unité de traitement de signal et la première unité de traitement de signal effectuent un traitement de signal sur des signaux de bandes de fréquences différentes, dans lequel l'unité de commutation comprend une première composante de commutation (261) et une deuxième composante de commutation (262),
dans lequel l'unité de commutation est couplée à l'amplificateur et à la troisième antenne par l'intermédiaire de la première composante de commutation, et couplée à la première unité de traitement de signal et à la deuxième unité de traitement de signal par l'intermédiaire de la deuxième composante de commutation,
dans lequel la première composante de commutation commute pour déterminer s'il faut effectuer un traitement de signal sur le premier signal ou sur le deuxième signal, et
la deuxième composante de commutation commute pour déterminer s'il faut utiliser la première unité de traitement de signal ou la deuxième unité de traitement de signal pour effectuer le traitement de signal.

10. Procédé (300) pour faire fonctionner le circuit de commutation radiofréquence (200) selon l'une quelconque des revendications 1 à 9, dans lequel le procédé comprend :
(320) la réception d'une pluralité de signaux d'entrée par une pluralité d'antennes (210, 220), et la transmission de la pluralité de signaux d'entrée respectivement vers une pluralité de ports d'entrée (231, 232) d'un diviseur de puissance (230) ;
(330) le mélange de la pluralité de signaux d'entrée en un signal intégré (So) par le diviseur de puissance, et l'émission du signal intégré à une unité de division de fréquence (240) ; et
(340) la division du signal intégré en une pluralité de composantes de signal (Sm, Sc) ayant des bandes de fréquences différentes par l'unité de division de fréquence.

11. Procédé selon la revendication 10, comprenant en outre :
le fait de déterminer une taille du diviseur de puissance sur la base d'un espace interne d'un dispositif électronique (100) où est disposé le circuit de commutation radiofréquence.

12. Procédé selon la revendication 10 ou la revendication 11, dans lequel la division du signal intégré en une pluralité de composantes de signal ayant des bandes de fréquences différentes par l'unité de division de fréquence comprend :
(341) la division du signal intégré en un premier groupe de composantes de signal comprenant une première composante de signal (Sm) par un diplexeur (241) ; et
(342) la division de la première composante de signal en un deuxième groupe de composantes de signal comprenant une deuxième composante de signal (Sc) par un extracteur (242).

13. Procédé selon l'une quelconque des revendications 10, 11 et 12, comprenant en outre :
(350) la réalisation d'un traitement de signal sur un signal associé à l'une de la pluralité de composantes de signal par une unité de traitement de signal (280), dans lequel le signal associé comprend la composante de signal.
